# EUROPEAN PATENT APPLICATION

(11) **EP 4 579 324 A1**
(43) Date of publication of application: **02.07.2025**
(21) Application number: 24223605.7
(22) Date of filing: 30.12.2024
(51) Int. Cl.: G02F 1/1333, G02F 1/1335

(54) **DISPLAY DEVICE**

(30) Priority: 29.12.2023 KR 20230197851
(71) Applicant: LG Display Co., Ltd., Seoul, 07336 (KR)
(72) Inventor: SONG, Kelly Sooyeun, 10845 Paju-si (KR)
(74) Representative: Ter Meer Steinmeister & Partner

(57) **Abstract**

Discussed is a display device and, more specifically, can include a display device capable of preventing or reducing mura defects by including a display panel, a functional member disposed on the display panel, and an adhesive layer disposed between the display panel and the functional member and adjusting the modulus and creep of the adhesive layer.

## Description

This application claims priority to Korean Patent Application No. 10-2023-0197851, filed in the Republic of Korea on December 29, 2023.

### BACKGROUND

### Technical Field

Embodiments of the disclosure relate to a display device, and more particularly, for example, to a display device that can prevent or reduce defects, such as mura while using a low-modulus optically transparent resin in the adhesive layer.

### Discussion of the Related Art

In recent days, there has been an increased demand for various types of display devices that can display an image more efficiently. Representative examples of such display devices include liquid crystal devices (LCD) and organic light emitting display devices (OLED).

Display devices with various forms and functions largely include a display panel that can display the image, and add a functional layer to supplement various functions, such as preventing damage from an external pressure and enhancing light extraction efficiency. The functional layer and the display panel can be bonded together using an adhesive, such as an optically transparent resin.

The adhesive layer formed using the optically transparent resin is required to enhance the optical properties of the display device, act as a buffer against external impacts, and enhance impact resistance. To enhance impact resistance, a resin having a low storage modulus may be used for the optically transparent resin.

The description provided in the discussion of the related art section may be background information for the subject technology.

### SUMMARY OF THE DISCLOSURE

With applying an optically transparent resin with a low modulus of elasticity to the adhesive layer, the stress applied to the display panel can be reduced. However, implementing high light resistance and high heat resistance, usually decreases the hardness of the resin and reduces its adhesive strength. Application of an optically transparent resin with a high modulus of elasticity, in contrast, can cause defects, such as mura.

Accordingly, there is a need for a display device that can prevent or reduce defects, such as mura.

There is a need for providing a display device that prevents or reduces mura defects by adjusting mechanical properties of the adhesive layer.

There is a further need for providing a display device having an enhanced adhesive strength by adjusting mechanical properties of the adhesive layer to mitigate external stress even at high temperatures.

It is another object of the disclosure to provide a display device that prevents or reduces mura defects by adjusting the thickness of the adhesive layer and the layers adjacent to the adhesive layer.

Other objects and advantages according to the present disclosure that are not mentioned can be understood based on following descriptions.

According to an aspect, a display device comprising a display panel outputting an image, a functional member disposed on the display panel, and an adhesive layer disposed between the display panel and the functional member is provided. The adhesive layer has a creep value of 100% or more and a storage modulus value of 55KPa or less at a first temperature, and/or has a creep value of 130% or more and a storage modulus value of 20KPa or less at a second temperature higher than the first temperature.

According to a further aspect, a display device comprising a display panel outputting an image, a first functional member disposed on the display panel, a second functional member disposed on the first functional member, and a first additional adhesive layer disposed between the first functional member and the second functional member is provided. The first additional adhesive layer has a creep value of 100% or more and/or a storage modulus value of 55KPa or less at a first temperature and has a creep value of 130% or more and a storage modulus value of 20KPa or less at a second temperature higher than the first temperature.

According to a further aspect, a display device comprising a display panel configured to output an image, a functional member disposed on the display panel and an adhesive layer disposed between the display panel and the functional member is provided. The adhesive layer has a creep value of about 100% or more at a first temperature, and/or has the creep value of about 130% or more at a second temperature higher than the first temperature. The adhesive layer has a creep value of at least 100% at a first temperature and at least 130% at a second temperature which is higher than the first temperature.

The creep value may represent a strain of the adhesive layer because of creep. The creep value may have a dimension of a length ratio and may be expressed as percentage. The creep value may indicate a percentage by which a length or size of the adhesive layer is deformed with respect to a reference configuration, e. g., an initial configuration generated upon application of the adhesive layer.

The storage modulus may relate to a mechanical property of the adhesive layer that measures a stiffness of the adhesive layer. The storage modulus may be also referred to as the Young's Modulus.

The display device according to any of the above aspects may include one or more of the following features:

The first temperature may be 25°C. The second temperature may be 105°C.

The adhesive layer may have a creep value of 250% or less and a storage modulus value of 34KPa or more at a temperature of 25°C.The adhesive layer may have a creep value of 350% or less and a storage modulus value of 4KPa or more at a temperature of 105°C.

The first additional adhesive layer may have a creep value of 250% or less and/or a storage modulus value of 34KPa or more at a temperature of 25°C.

The first additional adhesive layer may have a creep value of 350% or less and/or a storage modulus value of 4KPa or more at a temperature of 105°C.

The adhesive layer may have a thickness of 150*µ*m or more. The adhesive layer may have a thickness of 500*µ*m or less. The adhesive layer may have a thickness between 150*µ*m and 500 *µ*m.

The first additional adhesive layer may have a thickness of 150*µ*m or more. The first additional adhesive layer may have a thickness of 500*µ*m or less.

The functional member may include a base substrate. The base substrate may have a thickness of 0.5 mm or more. The base substrate may have a thickness of 1.0 mm or less. The base substrate may have a thickness between 0.5 mm and 1.0 mm.

The base substrate may include an upper base substrate and a lower base substrate facing each other. At least one of the upper base substrate and the lower base substrate may have a thickness of 0.5 mm or more. At least one of the upper base substrate and the lower base substrate may have a thickness of 1.0 mm or less.

The display panel may include a display substrate. The display substrate may have a thickness of 0.5 mm or more. The display substrate may have a thickness of 1.0 mm or less.

The display panel may include the display substrate. The display substrate may include an upper display substrate and a lower display substrate. The display panel may include a column spacer disposed on the upper display substrate or the lower display substrate. The display panel may include a display liquid crystal layer positioned between the upper display substrate and the lower display substrate. The column spacer may be distributed at an arrangement density of 100 ppm or more. The column spacer may be distributed at an arrangement density of 750 ppm or less. The column spacer may be distributed at an arrangement density between 100 ppm and 750 ppm.

The display panel may include a light emitting element. The light emitting element may include a first electrode disposed on the display substrate. The light emitting element may include a light emitting layer disposed on the first electrode. The light emitting element may include a second electrode disposed on the light emitting layer. The light emitting element may be any one of an organic electroluminescent element, a quantum dot light emitting element, a micro light emitting diode LED, and a mini LED.

The functional member may be any one of a cover window, a touch panel, a barrier panel, and a light control film.

A ratio of the storage modulus (MR) of the second temperature to the first temperature for the adhesive layer may range from 0.117 to 0.370. A ration of the creep value (CR) of the second temperature to the first temperature for the adhesive layer may range from 0.975 to 1.513. A ratio of the MR to CR of the adhesive layer may range from about 0.120 to about 0.290.

The display device may further comprise a third functional member disposed on the second functional member. The display device may further comprise a second additional adhesive layer disposed between the second functional member and the third functional member. The second additional adhesive layer may have a creep value of about 100% or more and/or a storage modulus value of about 55KPa or less at the first temperature. The second additional adhesive layer may have a creep value of about 130% or more and/or a storage modulus value of about 20KPa or less at the second temperature.

The second additional adhesive layer may have a thickness of 150*µ*m or more. The second additional adhesive layer may have a thickness of 500*µ*m or less.

The adhesive layer may have a storage modulus value of 55KPa or less at the first temperature. The adhesive layer may have a storage modulus value of 20KPa or less at the second temperature.

A display device provided according to any of the above aspects prevents or reduces the presence of mura defects.

A display device provided according to any of the above aspects prevents or reduces the presence of mura defects by adjusting the modulus and creep of the adhesive layer.

A display device provided according to any of the above aspects has an enhanced adhesive strength by adjusting the modulus and creep of the adhesive layer to mitigate external stress even at high temperatures.

A display device provided according to any of the above aspects prevents or reduces the presence of mura defects by adjusting the thickness of the adhesive layer and the layers adjacent to the adhesive layer.

A display device provided according to any of the above aspects may be capable of low power consumption by enhancing the lifespan by preventing or reducing mura defects.

It is to be understood that both the foregoing general description and the following detailed description of the present disclosure are example and explanatory and are intended to provide further explanation of the disclosure as claimed.

### BRIEF DESCRIPTION OF THE DRAWINGS

The above and other objects, features, and advantages of the disclosure will be more clearly understood from the following detailed description, taken in conjunction with the accompanying drawings, in which:
FIG. 1 is a view illustrating a system configuration of a display device according to aspects of the disclosure;
FIG. 2 is a cross-sectional view schematically illustrating a structure of a display device according to aspects of the disclosure;
FIG. 3 is a cross-sectional view schematically illustrating a structure of a liquid crystal display device according to aspects of the disclosure;
FIG. 4 is a cross-sectional view schematically illustrating a structure of an organic electroluminescent display device according to aspects of the disclosure; and
FIGS. 5, 6, 7, and 8 are cross-sectional views illustrating another example of a display device according to aspects of the disclosure.

Throughout the drawings and the detailed description, unless otherwise described, the same drawing reference numerals should be understood to refer to the same elements, features, and structures. The sizes, lengths, and thicknesses of layers, regions and elements, and depiction thereof can be exaggerated for clarity, illustration, and convenience.

### DETAILED DESCRIPTION OF THE EMBODIMENTS

In the following description of examples or embodiments of the disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the disclosure, detailed descriptions of well-known functions and components incorporated herein will be omitted when it is determined that the description can make the subject matter in some embodiments of the disclosure rather unclear. The terms such as "including", "having", "containing", "constituting" "make up of', and "formed of' used herein are generally intended to allow one or more components to be added unless the terms are used with the term "only". As used herein, singular forms are intended to include plural forms unless the context clearly indicates otherwise.

Terms, such as "first", "second", "A", "B", "(A)", "(B)", "(a)," and "(b)," can be used herein to describe elements of the disclosure. Each of these terms is not used to define essence, order, sequence, or number of elements etc., but is used merely to distinguish the corresponding element from other elements.

The terms, such as "below," "lower," "above," "upper" and the like, can be used herein to describe a relationship between element(s) as illustrated in the drawings. It will be understood that the terms are spatially relative and based on the orientation depicted in the drawings.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element can be included in at least one of two or more elements that "are connected or coupled to", "contact or overlap", etc. each other.

It should be understood that the term "at least one" includes all combinations related with any one item. For example, "at least one among a first element, a second element and a third element" can include all combinations of two or more elements selected from the first, second and third elements as well as each individual element of the first, second and third elements.

When time relative terms, such as "after," "subsequent to," "next," "before," and the like, are used to describe processes or operations of elements or configurations, or flows or steps in operating, processing, manufacturing methods, these terms can be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that can be caused by various factors (e.g., process factors, internal or external impact, noise, etc.) even when a relevant description is not specified. Further, the term "can" fully encompasses all the meanings of the term "may".

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" can apply, for example, to a separate circuit or structure, an integrated circuit, a computational block of a circuit device, or any structure configured to perform a described function as should be understood to one of ordinary skill in the art.

Hereinafter, various embodiments of the disclosure are described in detail with reference to the accompanying drawings. All the components of each display device according to all embodiments of the present disclosure are operatively coupled and configured.

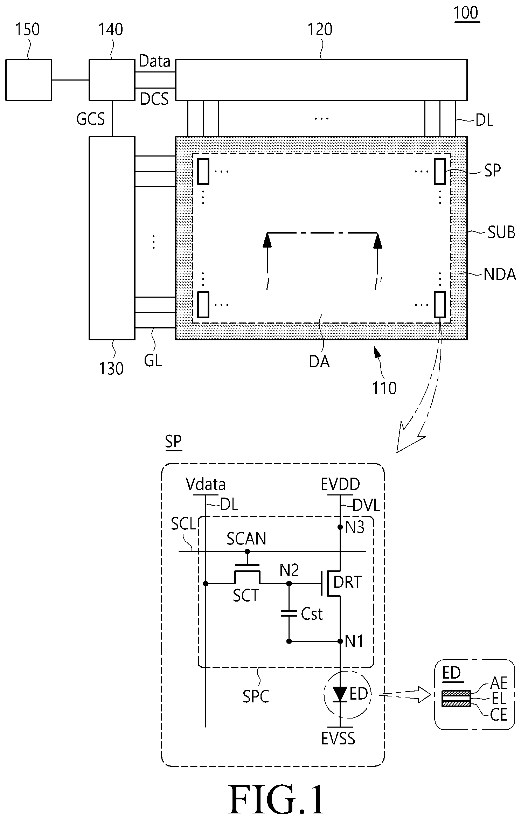

FIG. 1 is a view illustrating a system configuration of a display device 100 according to aspects of the disclosure.

Referring to FIG. 1, a display driving system of the display device 100 according to aspects of the disclosure may include a display panel 110 and display driving circuits for driving the display panel 110, and the like.

The display panel 110 may include a display area DA in which images can be displayed and a non-display area NDA in which no image is displayed. The non-display area NDA is configured to surround the display area DA. The display panel 110 may include a plurality of subpixels SP disposed on a substrate SUB for image display. The plurality of subpixels SP may be configured to display the image. The display panel 110 may further include a circuit part configured to operate the plurality of subpixels SP

The display panel 110 can include a plurality of signal lines disposed on the substrate SUB. For example, the plurality of signal lines can include data lines DL, gate lines GL, driving voltage lines, and the like.

Each of the plurality of data lines DL is disposed as extending in a first direction (e.g., a column direction or a row direction), and each of the plurality of gate lines GL is disposed as extending in a second direction crossing the first direction (e.g., a row direction or a column direction).

The display driving circuits can be a circuit for driving the display panel, and include a data driving circuit 120 and a gate driving circuit 130, a controller 140 for controlling the data driving circuit 120 using data driving control signals DCS and the gate driving circuit 130 using gate driving control signals GCS, and other circuit components. The controller 140 can supply image data DATA readable by the data driving circuit 130.

The data driving circuit 120 can output data signals (also referred to as data voltages) corresponding to an image signal to the plurality of data lines DL. The gate driving circuit 130 can generate gate signals and output the gate signals to the plurality of gate lines GL. The controller 140 can convert the input image data input from an external host 150 to meet the data signal format used in the data driving circuit 120 and supply the converted image data to the data driving circuit 120.

The data driving circuit 120 can include one or more source driver integrated circuits. For example, each source driver integrated circuit can be connected with the display panel 110 by a tape automated bonding (TAB) method or connected to a bonding pad of the display panel 110 by a chip on glass (COG) or chip on panel (COP) method or can be implemented by a chip on film (COF) method and connected with the display panel 110.

The gate driving circuit 130 can be connected to the display panel 110 by a tape automatic bonding (TAB) method, connected to a bonding pad of the display panel 110 by a COG or COP method, connected to the display panel 110 by a COF method, or can be formed in the non-display area NDA of the display panel 110 by a gate in panel (GIP) method.

Referring to FIG. 1, in the display device 100 according to aspects of the disclosure, each subpixel SP can include a light emitting element ED and a pixel driving circuit SPC for driving the light emitting element ED. The pixel driving circuit SPC can include a driving transistor DRT, a scan transistor SCT, and a storage capacitor Cst. As one example, each subpixel SP can include a 7T1C structure in which seven transistors and one capacitor are disposed. For example, 3T1C, 4T1C, 5T1C, 3T2C, 4T2C, 5T2C, 6T2C, 7T1C, 7T2C, 8T2C structures, etc. are also possible. And more or less transistors and capacitors could be included.

The driving transistor DRT can control a current flowing to the light emitting element ED to drive the light emitting element ED. The scan transistor SCT can transfer the data voltage Vdata to the second node N2 which is the gate node of the driving transistor DRT. The storage capacitor Cst can be configured to maintain a voltage for a predetermined period of time.

The light emitting element ED can include an anode electrode AE and a cathode electrode CE, and a light emitting layer EL positioned between the anode electrode AE and the cathode electrode CE. For example, the light emitting layer EL can include one or more of a hole injection layer (HIL), a hole transmitting layer (HTL), an electron transmitting layer (ETL) and an electron injection layer (EIL). The anode electrode AE can be a pixel electrode involved in forming the light emitting element ED of each subpixel SP and can be electrically connected to the first node N1 of the driving transistor DRT. The cathode electrode CE can be a common electrode involved in forming the light emitting elements ED of all the subpixels SP, and a ground voltage EVSS can be applied thereto.

For example, the light emitting element ED can be an organic light emitting diode OLED, an inorganic light emitting diode (LED), or a quantum dot light emitting element, which is a self-luminous semiconductor crystal.

The driving transistor DRT is a transistor for driving the light emitting element ED, and can include a first node N1, a second node N2, and a third node N3. The first node N1 can be a source node or a drain node of the driving transistor DRT, and can be electrically connected to the anode electrode AE of the light emitting element ED. The second node N2 is a gate node of the driving transistor DRT and can be electrically connected to the source node or drain node of the scan transistor SCT. The third node N3 can be a drain node or a source node of the driving transistor DRT, and can be electrically connected to a driving voltage line DVL that supplies the driving voltage EVDD. For convenience of description, in the example described below, the first node N1 can be a source node and the third node N3 can be a drain node.

The scan transistor SCT can switch the connection between the data line DL and the second node N2 of the driving transistor DRT. In response to the scan signal SCAN supplied from the scan line SCL which is a kind of the gate line GL, the scan transistor SCT can control connection between the second node N2 of the driving transistor DRT and a corresponding data line DL among the plurality of data lines DL. When the scan transistor SCT is turned on in response to the scan signal SCAN supplied from the scan line SCL, the data voltage Vdata can be transferred to the second node N2 of the driving transistor DRT.

The storage capacitor Cst can be configured between the first node N1 and second node N2 of the driving transistor DRT.

The structure of the subpixel SP illustrated in FIG. 1 is merely an example for description, and can further include one or more transistors, or one or more storage capacitors. The plurality of subpixels SP can have the same structure, or some of the plurality of subpixels SP can have a different structure. Each of the driving transistor DRT and the scan transistor SCT can be an n-type transistor or a p-type transistor.

The display device 100 according to example embodiments of the disclosure can have a top emission structure or a bottom emission structure. The top emission structure is described below as an example. For example, in the top emission structure, the anode electrode AE can be a reflective metal, and the cathode electrode CE can be a transparent conductive film.

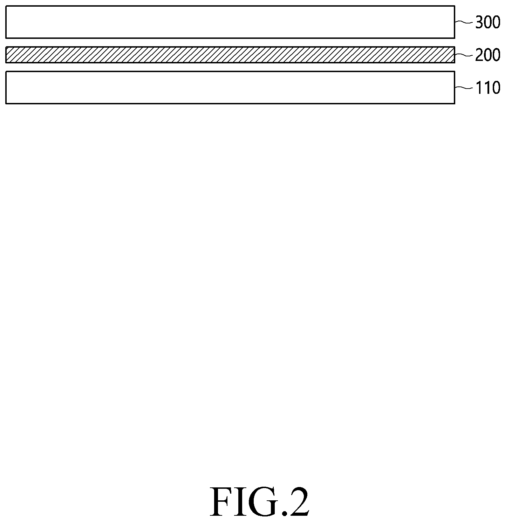

FIG. 2 is a cross-sectional view schematically illustrating a structure of a display device according to aspects of the disclosure. For example, FIG. 2 is a view schematically illustrating a cross section taken along line I-I' of FIG. 1. Elements identical or similar to those described with reference to FIG. 1 are omitted from the following description or briefly described below.

Referring to FIG. 2, a display device 100 according to aspects of the disclosure can include a display panel 110, an adhesive layer 200, and a functional member 300, and the like. For example, the display device 100 can include a display panel 110 that outputs an image, a functional member 300 disposed on or over the display panel 110, and an adhesive layer 200 disposed between the display panel 110 and the functional member 300.

The display panel 110 can include any display panel capable of outputting an image, such as a liquid crystal display panel including a liquid crystal layer, an organic electroluminescent display panel including an organic electroluminescent element, a quantum dot display panel including a quantum dot light emitting element, a micro LED display panel including a micro LED, and a mini LED display panel including a mini LED, and the like.

An adhesive layer 200 is disposed between the display panel 110 and the functional member 300. Specifically, the adhesive layer 200 may be disposed on the display panel 110, and the functional member 300 may be disposed on the adhesive layer 200. The adhesive layer 200 may bond the display panel 110 and the functional member 300. For example, the adhesive layer 200 may bond the display panel 110 and the functional member 300 using an optically transparent resin or the like.

As one example, the adhesive layer 200 can be formed of an optically transparent resin to enhance optical properties of the display device 100 and act as a buffer in an external impact, thereby enhancing impact resistance.

When the adhesive layer 200 has a low modulus of elasticity, the stress applied to the display panel can be reduced or minimized to enhance impact resistance at cost of a lower hardness and decreased adhesive strength. Further, when the modulus of elasticity of the adhesive layer 200 is too low, it is difficult to control the process due to being-pushed of the adhesive in the bonding process, and defects due to foreign matters can occur, and the quality can be deteriorated.

Meanwhile, when the adhesive layer 200 has a high modulus of elasticity, the hardness is guaranteed and the adhesive force can be maintained, but defects such as mura can occur.

Accordingly, an additional physical property factor was derived to allow the adhesive layer 200 to have a hardness enough to maintain adhesive strength while having a low modulus of elasticity to mitigate defects such as mura.

Creep is a physical property indicating the degree of deformation over time when constant stress is applied. It was identified that when the creep increased even when the adhesive layer 200 had a low modulus of elasticity, in particular storage modulus, the adhesive strength was maintained, and it was effective to mitigate mura.

The display device 100 according to example embodiments of the disclosure can prevent or reduce mura defects by adjusting the storage modulus and creep of the adhesive layer 200. Further, the display device 100 according to example embodiments of the disclosure can have an enhanced adhesive strength by adjusting the storage modulus and creep of the adhesive layer 200 to relieve stress to the outside even at high temperatures.

The adhesive layer 200 can have a low modulus of elasticity and a high creep to prevent or reduce mura defects, and can have an enhanced adhesive strength by relieving external stress even at high temperatures.

As one example, the adhesive layer 200 can have a creep value of 100% or more and a storage modulus value of 55 KPa or less at a first temperature, a creep value of 130% or more, and a storage modulus value of 20 KPa or less at a second temperature higher than the first temperature.

Specifically, the adhesive layer 200 can have a creep value of 100% or more and a storage modulus value of 55 KPa or less at a temperature of 25°C, a creep value of 130% or more, and a storage modulus value of 20 KPa or less at a temperature of 105°C.

The adhesive layer 200 can have a creep value of 250% or less and a storage modulus value of 34 KPa or more at a temperature of 25°C.

The adhesive layer 200 can have a creep value of 350% or less and a storage modulus value of 4 KPa or more at a temperature of 105°C.

For example, the adhesive layer 200 can have a creep value of 100% or more and 250% or less, a storage modulus value of 34 KPa or more and 55 KPa or less at the first temperature such as 25°C.

For example, the adhesive layer 200 can have a creep value of 130% or more and 350% or less, and a storage modulus value of 4 KPa or more and 20 KPa or less at the second temperature such as 105°C.

Meanwhile, in example embodiments of the disclosure, creep deformation was measured by applying a constant shear stress corresponding to a force of 10,000 Pa for a predetermined time interval to an adhesive layer sample at 25°C and 105°C. Specifically, after forming an adhesive layer sample in a circular shape having a diameter of 8 mm and a thickness of 1 mm, a constant shear stress corresponding to a force of 10,000 Pa was applied for 10 minutes at 25°C and 105°C using ARES-G2 of the company "TA instruments", a rotational rheometer for dynamic-mechanical analysis, to measure creep deformation of the adhesive layer. After creep measurement, a force was applied at 0 Pa for 10 minutes to measure recovery, which is the recovery rate against change.

When the creep value and the storage modulus value meet the above-described ranges at temperatures of 25°C and 105°C, the adhesive layer 200 can prevent or reduce mura defects, and can have an enhanced adhesive strength by relieving stress to the outside even at high temperatures.

As one example, the adhesive layer 200 can also have a thickness of 150 µm or more and 750 µm or less, a thickness of 200 µm or more and 400 µm or less, and a thickness of 250 µm or more and 350 µm or less. Further, other suitable thicknesses of the adhesive layer 200 are also possible, as long as the display panel can reduce the stress received from the outside to prevent or reduce mura defects, and can have an enhanced adhesive strength by relieving the stress to the outside even at high temperatures.

When the thickness of the adhesive layer 200 meets the above-described ranges, the display panel can reduce the stress received from the outside to prevent or reduce mura defects, and can have an enhanced adhesive strength by relieving the stress to the outside even at high temperatures.

The functional member 300 can be attached on the adhesive layer 200. Specifically, functional member 300 can be attached on one side of the adhesive layer 200. The display panel 110 can be attached on the other side of the adhesive layer 200.

As one example, he functional member 300 can include various substrates or panels.

For example, the functional member 300 can be a cover window for protecting the display device, or can be a functional panel such as a touch panel or a 3D barrier panel. The functional member 300 can be a light control film for adjusting the viewing angle area of the display device. In example embodiments of the disclosure, the functional member is not limited to the above-described substrates or panels.

As one example, a single functional member 300 can be disposed on or over the display panel 110. Further, two or more functional members 300 can be disposed to overlap each other on the display panel 110.

When the two or more functional members 300 are disposed to overlap each other on the display panel 110, the above-described adhesive layer 200 can be disposed between the functional members 300 so that the functional members 300 can be bonded together. Further, the above-described adhesive layer 200 can be disposed between the display panel 110 and the functional member 300 so as to bond the display panel 110 and the functional member 300.

As one example, the functional member 300 can include a base substrate.

The base substrate can have a thickness of 0.5 mm or more and 1.0 mm or less. When the thickness of the base substrate meets the above-mentioned range, stress can be released, preventing delamination between layers.

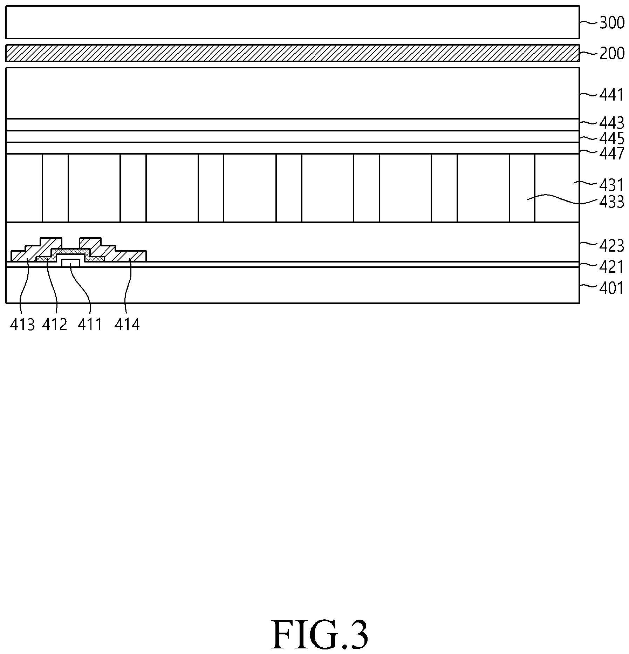

FIG. 3 is a cross-sectional view schematically illustrating a structure of a liquid crystal display device according to example embodiments of the disclosure. For example, FIG. 3 is a view schematically illustrating a cross section taken along line I-I' of FIG. 1. Descriptions of what is identical or similar to those described in connection with FIGS. 1 and 2 can be omitted or briefly described below.

Referring to FIG. 3, a display device 100 according to example embodiments of the disclosure can include a display panel 110, an adhesive layer 200, and a functional member 300, and the like. The adhesive layer 200 can be disposed between the display panel 110 and the functional member 300. The display panel 110 can be a liquid crystal display panel including a display liquid crystal layer 431.

As one example, the display panel 110 can include at least one thin film transistor disposed on a lower display substrate 401 and a display liquid crystal layer 431 disposed on the thin film transistor.

The display panel 110 can further include an upper display substrate 441. As one example, the display liquid crystal layer 431 can be disposed between the lower display substrate 401 and the upper display substrate 441.

As one example, at least one of the lower display substrate 401 or the upper display substrate 441 can have a thickness of 0.5 mm or more and 1.0 mm or less.

For example, the lower display substrate 401 can have a thickness of 0.5 mm or more and 1.0 mm or less. When the thickness of the lower display substrate 401 meets the above-mentioned range, stress can be released, preventing delamination between layers.

As one example, the upper display substrate 441 can have a thickness of 0.5 mm or more and 1.0 mm or less. When the thickness of the upper display substrate 441 meets the above-mentioned range, stress can be released, preventing delamination between layers.

The thin film transistor disposed on a lower display substrate 401 can include a gate electrode 411 formed on the lower display substrate 401, a gate insulation layer 421 formed on the gate electrode 411, an active layer 412 formed on the gate insulation layer 421, and a source electrode 413 and a drain electrode 414 formed on the active layer 412. A protection layer 423 can be formed on the thin film transistor. Specifically, the protection layer 423 can be disposed on the thin film transistor and the lower display substrate 401.

A black matrix 443 and a color filter layer 445 can be disposed on the upper display substrate 441. The black matrix 443 can be disposed between the upper display substrate 441 and the color filter layer 445. The black matrix 443 is used to prevent light from leaking into areas where actual images are not implemented, such as areas where gate lines, data lines, and thin film transistors are formed, to prevent deterioration of image quality, and can block light from being transmitted to these areas.

The color filter layer 445 can include a plurality of color filters, such as R, G, and B color filters and can implement an image by implementing a color corresponding to the light transmitted therethrough. In this case, in the color filter layer 445, filters of the same color can be arranged in a strip shape. Further, an overcoat layer 447 can be formed on the color filter layer 445 to planarize the upper display substrate 441 and protect the color filter layer 445.

A column spacer 433 can be formed between the lower display substrate 401 and the upper display substrate 441. In other words, the column spacer 433 can be formed on the lower display substrate 401 or the upper display substrate 441. For example, the column spacer 433 can be disposed on the overcoat layer 447 formed on the upper display substrate 441. In other words, the column spacer 433 can be formed between the lower display substrate 401 and the overcoat layer 447.

The column spacer 433 can maintain a gap between the lower display substrate 401 and the upper display substrate 441. The thickness of the display liquid crystal layer 431 can be kept constant by the column spacer 433. For example, the column spacer 433 can be disposed between the display liquid crystal layer 431.

As one example, the column spacer 433 can be distributed at an arrangement density of 100 ppm or more and 750 ppm or less.

When the arrangement density of the column spacer 433 meets the above-mentioned range, even when the display panel 110 and the functional member 300 are bonded by the adhesive layer 200, the cell gap can be kept constant, preventing or reducing mura defects.

The column spacer 433 can contact the protection layer of the lower display substrate 401 to keep the cell gap of the display panel 110 constant.

The adhesive layer 200 and the functional member 300 can be disposed on the upper display substrate 441 of the display panel 110, and the display panel 110 and the functional member 300 can be bonded by the adhesive layer 200. When the two or more functional members 300 are disposed to overlap each other on the display panel 110, the above-described adhesive layer 200 can be disposed between the functional members 300 so that the functional members 300 can be bonded together.

A backlight unit can be disposed under the display panel 110. The display panel 110 can generate an image to be provided to the user using the light provided from the backlight unit.

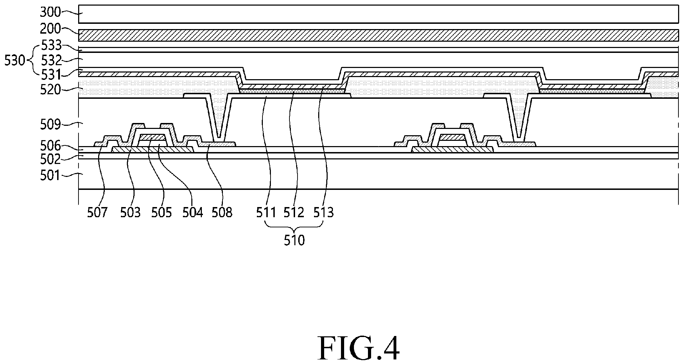

FIG. 4 is a cross-sectional view schematically illustrating a structure of an organic electroluminescent display device according to aspects of the disclosure. For example, FIG. 4 is a view schematically illustrating a cross section taken along line I-I' of FIG. 1. What is identical or similar to those described with reference to FIGS. 1 to 3 is omitted from the following description or briefly described below.

Referring to FIG. 4, a display device 100 according to aspects of the disclosure can include a display panel 110, an adhesive layer 200, and a functional member 300, and the like. The display panel 110 can include an organic electroluminescent display panel including an organic electroluminescent element 510

As one example, the display panel 110 can include at least one thin film transistor disposed on the display substrate 501 and an organic electroluminescent element 510 disposed on the thin film transistor

The thin film transistor can include an active layer 503, a gate electrode 505, a source electrode 507, and a drain electrode 508. A planarization layer 509 can be disposed on the thin film transistor.

The organic electroluminescent element 510 can include a first electrode 511, a light emitting layer 512, and a second electrode 513. For example, the light emitting layer 512 can include one or more of a hole injection layer (HIL), a hole transmitting layer (HTL), an electron transmitting layer (ETL) and an electron injection layer (EIL).

Specifically, the display substrate 501 can have a thickness of 0.5 mm or more and 1.0 mm or less. When the thickness of the display substrate 501 meets the above-mentioned range, stress can be released, preventing delamination between layers.

A buffer layer 502 can be disposed on the display substrate 501. The active layer 503 can be disposed on the buffer layer 502.

The buffer layer 502 can include an inorganic insulating material, such as silicon oxide (SiOx), silicon nitride (SiNx), or silicon oxynitride (SiON).

In FIG. 4, the buffer layer 502 has a single-layer structure, but the buffer layer 502 of the disclosure can have a multi-layer structure. The buffer layer 502 is to prevent moisture from permeating from the outside.

If the buffer layer 502 has a multi-layer structure, layers including at least three inorganic insulating materials among inorganic materials, such as silicon oxide (SiOx), silicon nitride (SiNx), or silicon oxynitride (SiON), can be alternately disposed.

In the following description, for convenience, a structure in which the buffer layer 502 is a single layer is described.

An active layer 503 of a thin film transistor can be disposed on the buffer layer 502.

The active layer 503 can be various types of semiconductor layers. For example, the active layer 503 can be one selected from among an oxide semiconductor, an amorphous silicon semiconductor, and a polysilicon semiconductor.

A gate insulation film 504 can be disposed on the active layer 503, and the gate electrode 505 can be disposed on the gate insulation film 504. Specifically, the gate insulation film 504 can be disposed on a portion of the upper surface of the active layer 503. The gate insulation film 504 is an insulating layer for insulating the active layer 503 and the gate electrode 505 from each other.

The gate insulation film 504 can include an inorganic insulating material, such as silicon oxide (SiOx), silicon nitride (SiNx), or silicon oxynitride (SiON).

Although FIG. 4 illustrates a structure in which the gate insulation film 504 is disposed on a portion of the upper surface of the active layer 503, and the gate insulation film 504 is disposed covering the active layer 503.

A gate electrode 505 of the thin film transistor can be disposed on the gate insulation film 504. Specifically, the gate insulation film 504 can be disposed between the active layer 503 and the gate electrode 505 of the thin film transistor.

The gate electrode 505 can include any one of metals, such as aluminum (Al), gold (Au), silver (Ag), copper (Cu), tungsten (W), molybdenum (Mo), chromium (Cr), tantalum (Ta), and titanium (Ti), or alloys thereof.

An inter-layer insulation layer 506 can be disposed on the gate electrode 505. Specifically, the inter-layer insulation layer 506 can be disposed on the buffer layer 502 and the gate electrode 505.

The inter-layer insulation layer 506 can include an inorganic insulating material such as silicon oxide (SiOx), silicon nitride (SiNx), or silicon oxynitride (SiON).

A source electrode 507 and a drain electrode 508 of the thin film transistor can be disposed on the inter-layer insulation layer 506 and can be spaced apart from each other.

In example embodiments of the disclosure, 507 can be the drain electrode, and 508 can be the source electrode. Further, 507 can be the source electrode, and 508 can be the drain electrode.

The source electrode 507 and the drain electrode 508 can include any one of metals, such as aluminum (Al), gold (Au), silver (Ag), copper (Cu), tungsten (W), molybdenum (Mo), chromium (Cr), tantalum (Ta), and titanium (Ti), or alloys thereof.

Each of the source electrode 507 and the drain electrode 508 can be connected with a portion of the upper surface of the active layer 503 through a contact hole provided in the inter-layer insulating layer 506.

A planarization layer 509 can be disposed on the display substrate 501 on which the source electrode 507 and the drain electrode 508 are disposed. The planarization layer 509 can be disposed to cover the inter-layer insulation layer 506, the source electrode 507 and the drain electrode 508.

A protection film including an inorganic insulating material can be further disposed under the planarization layer 509.

A first electrode 511 of the organic electroluminescent element 510 can be disposed on a portion of the upper surface of the planarization layer 509.

The first electrode 511 can be electrically connected with the drain electrode 508 of the thin film transistor through a contact hole provided in the planarization layer 509. Although FIG. 4 illustrates a structure in which the first electrode 511 is connected with the drain electrode 508 of the thin film transistor, and the first electrode 511 can be connected with the source electrode 507 of the thin film transistor.

Although FIG. 4 illustrates a structure in which the first electrode 511 is a single layer. For example, the first electrode 511 can have a multi-layer structure of two or more layers.

The first electrode 511 can include a reflective electrode. For example, the first electrode 511 can comprise a metal material such as Au, W, Pt, Si, Ir, Ag, Cu, Ni, Ti, or Cr, and an alloy thereof.

Specifically, if the first electrode 511 has a single-layer structure, the first electrode 511 can be a reflective electrode including a reflective conductive material.

If the first electrode 511 has a multi-layer structure, at least one layer can be a reflective electrode including a reflective conductive material. The other layers than the reflective electrode can be layers formed of a transparent conductive material such as ITO indium tin oxide or IZO indium zinc oxide.

A bank 520 can be disposed on the planarization layer 509. The bank 520 can include an insulating material. As an example, the bank 520 can include an organic insulating material such as acryl resin, epoxy resin, phenolic resin, polyamide resin, and/or polyimide resin, etc. Alternatively, the bank 520 can include an inorganic insulating material such as silicon nitride, aluminum nitride, zirconium nitride, titanium nitride, hafnium nitride, tantalum nitride, silicon oxide, aluminum oxide, or titanium oxide, etc. Further, the bank 520 can include a black dye in order to absorb light incident from the outside.

The bank 520 can have a matrix-type lattice structure in the whole display substrate 501. The bank 520 surrounds the edge of the first electrode 511 and exposes a portion of the first electrode 511. The bank 520 can include an opening that exposes a portion of the first electrode 511 to define an emission area EA.

The bank 520 can define an emission area EA and a non-emission area NEA in the display area DA of the display device 100. For example, the area in which the bank 520 is disposed in the display area DA can be a non-emission area NEA, and the area in which the bank 520 is not disposed in the display area DA can be an emission area EA.

A light emitting layer 512 of the organic electroluminescent element 510 can be disposed on the first electrode 511.

The light emitting layer 512 can be disposed on a portion of the upper surface of the first electrode 511 exposed by the bank 520.

Although FIG. 4 illustrates a structure in which the light emitting layer 512 is a single layer. The light emitting layer 512 can be formed of a multi-layered organic layer.

The light emitting layer 512 can emit light of at least one of red (R), green (G), and blue (B). The light emitting layer 512 can emit other colors of light, such as white (W). Further, the light emitting layer 512 can emit light of cyan, magenta, or yellow, etc..

In the display device 100 according to example embodiments of the disclosure, the light emitting element has been described as an organic electroluminescent element 510, but the light emitting element can include any one of an organic electroluminescent element, a quantum dot light emitting element, a micro LED, or a mini LED.

A second electrode 513 of the organic electroluminescent element 510 can be disposed on the display substrate 501 on which the light emitting layer 512 is disposed.

The second electrode 513 can include a transparent conductive material such as ITO indium tin oxide or IZO indium zinc oxide or a semi-transmissive material.

Although FIG. 4 illustrates a structure in which the second electrode 513 is a single layer, and the second electrode 213 can have a multi-layer structure of two or more layers.

An encapsulation layer 530 can be disposed on the second electrode 513.

Specifically, the encapsulation layer 530 can include a first encapsulation layer 531 disposed on the second electrode 513, a second encapsulation layer 532 disposed on the first encapsulation layer 531, and a third encapsulation layer 533 disposed on the second encapsulation layer 532. The first and third encapsulation layers 531 and 533 can include an inorganic insulating material, and the second encapsulation layer 532 can include an organic insulating material. The first and third encapsulation layers 531 and 533 can be made of an inorganic insulating material such as silicon oxide SiOx, silicon nitride SiNx, silicon oxynitride SiNxOy, or aluminum oxide AlyOz. The second encapsulation layer 532 can be made of an organic insulating material, for example, silicon oxycarbon SiOxCz or acrylic or epoxy-based resin.

The first and third encapsulation layers 531 and 533 including the inorganic insulating material can serve to prevent penetration of moisture and oxygen, and the second encapsulation layer 532 including the organic insulating material can serve to delay the movement of a small amount of moisture and oxygen permeated through the third encapsulation layer 533.

The adhesive layer 200 and the functional member 300 can be disposed on the third encapsulation layer 533 of the display panel 110, and the display panel 110 and the functional member 300 can be bonded by the adhesive layer 200.

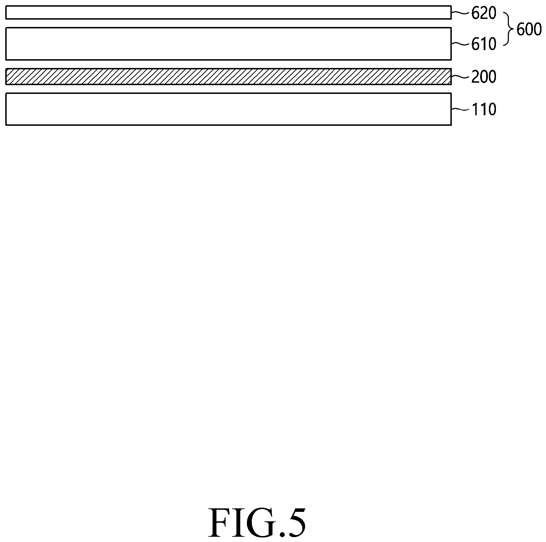

FIGS. 5, 6, 7, and 8 are cross-sectional views illustrating another example of a display device according to example embodiments of the disclosure. For example, FIGS. 5-8 are each a view schematically illustrating a cross section taken along line I-I' of FIG. 1. Those identical or similar to what has been described with reference to FIGS. 1 to 4 are omitted from the following description or are briefly described.

FIG. 5 is a view illustrating an example in which the functional member is a cover window 600.

Referring to FIG. 5, a display device 100 according to aspects of the disclosure can include a display panel 110, an adhesive layer 200, and a cover window 600. The adhesive layer 200 can be disposed between the display panel 110 and the cover window 600.

The cover window 600 can include a glass substrate 610. Further, the cover window 600 can further include a protective layer 620 disposed on the glass substrate 610.

The glass substrate 610 can be tempered glass. The protective layer 620 can be disposed on the front surface of the display device 100. The protective layer 620 can transmit the image provided from the display panel 110 as it is, and can protect the glass substrate 610 from an external impact.

As one example, the glass substrate 610 can have a thickness of 0.5 mm or more and 1.0 mm or less. When the thickness of the glass substrate 610 meets the above-described ranges, stress can be relieved to prevent delamination between layers.

The adhesive layer 200 and the glass substrate 610 of the cover window 600 can be disposed on the display panel 110, and the display panel 110 and the cover window 600 can be bonded by the adhesive layer 200.

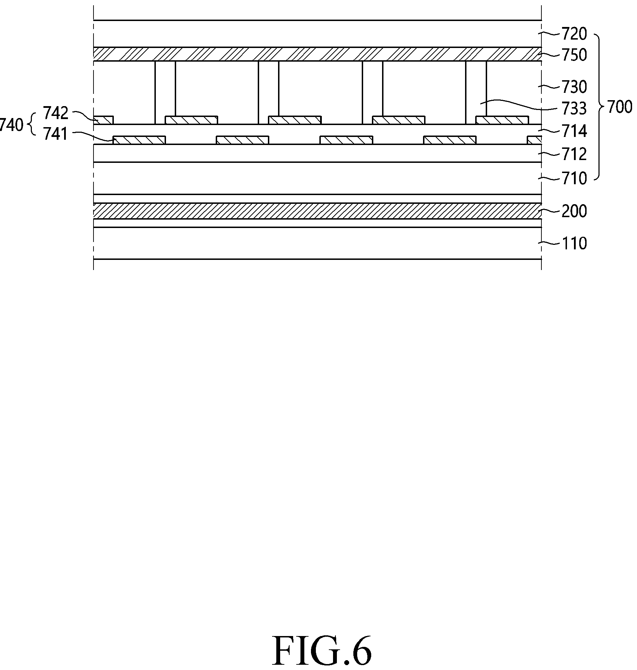

FIG. 6 is a view illustrating an example in which the functional member is a barrier panel 700.

Referring to FIG. 6, a display device 100 according to aspects of the disclosure can include a display panel 110, an adhesive layer 200, and a barrier panel 700, and the like. The adhesive layer 200 can be disposed between the display panel 110 and the barrier panel 700.

The barrier panel 700 can include a lower base substrate 710, an upper base substrate 720 and a barrier liquid crystal layer 730 positioned between the lower base substrate 710 and the upper base substrate 720.

The base substrate can include the lower base substrate 710 and the upper base substrate 720 facing each other.

As one example, at least one of the lower base substrate 710 or the upper base substrate 720 can have a thickness of 0.5 mm or more and 1.0 mm or less.

For example, the lower base substrate 710 can have a thickness of 0.5 mm or more and 1.0 mm or less. When the thickness of the lower base substrate 710 meets the above-described ranges, stress can be relieved to prevent delamination between layers.

For example, the upper base substrate 720 can have a thickness of 0.5 mm or more and 1.0 mm or less. When the thickness of the upper base substrate 720 meets the above-described ranges, stress can be relieved to prevent delamination between layers.

The light transmitting areas formed in the barrier panel 700 by an electrical signal can each have a bar shape. The display panel 110 can generate a left eye image provided to the left eye of the user and a right eye image provided to the right eye of the user using the light separated by the barrier panel 700.

The barrier panel 700 can be controlled to selectively provide a 2D image and a 3D image to the user.

Further, the barrier panel 700 can include channel electrodes 740 positioned side by side between the lower base substrate 710 and the barrier liquid crystal layer 730, and a common electrode layer 750 positioned between the barrier liquid crystal layer 730 and the upper base substrate 720.

The channel electrodes 740 can include first channel electrodes 741 and second channel electrodes 742 insulated by the channel insulation film 714. The channel insulation film 714 can be disposed on the first channel electrodes 741 and the barrier insulation film 712. The positions of the light blocking areas and the light transmitting areas formed by the voltage applied to each channel electrode 740 in the barrier panel 700 can be precisely controlled.

A barrier insulation film 712 can be positioned between the lower base substrate 710 and the channel electrodes 740. The barrier insulation film 712 can be positioned on the lower base substrate 710. The barrier insulation film 712 can prevent damage to the lower base substrate 710 due to a process of forming the channel electrodes 740. The barrier insulation film 712 can include an insulating material.

A barrier spacer 733 can be formed between the lower base substrate 710 and the upper base substrate 720. The barrier spacer 733 can maintain a gap between the lower base substrate 710 and the upper base substrate 720. The thickness of the barrier liquid crystal layer 730 can be kept constant by the barrier spacer 733. For example, the barrier spacer 733 can be disposed between the barrier liquid crystal layer 730. The barrier spacer 733 can be disposed to cover the second channel electrodes 742 and the channel insulation film 714.

As one example, the barrier spacer 733 can be distributed at an arrangement density of 100 ppm or more and 750 ppm or less.

When the arrangement density of the barrier spacer 733 meets the above-described ranges, even if the display panel 110 and the barrier panel 700 are bonded to each other by the adhesive layer 200, the cell gap can be kept constant, thereby preventing or reducing mura defects.

The adhesive layer 200 and the barrier panel 700 as the functional member 300 can be disposed on the upper display substrate 441 of the display panel 110, and the display panel 110 and the barrier panel 700 as the functional member 300 can be bonded by the adhesive layer 200.

The adhesive layer 200 and the lower base substrate 710 of the barrier panel 700 can be disposed on the display panel 110, and the display panel 110 and the barrier panel 700 can be bonded by the adhesive layer 200.

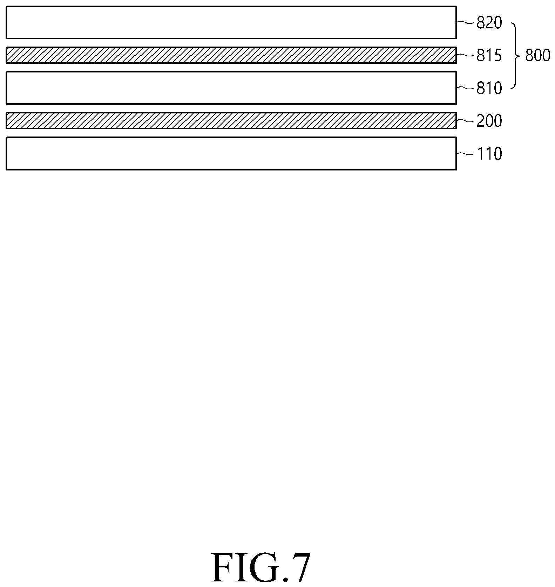

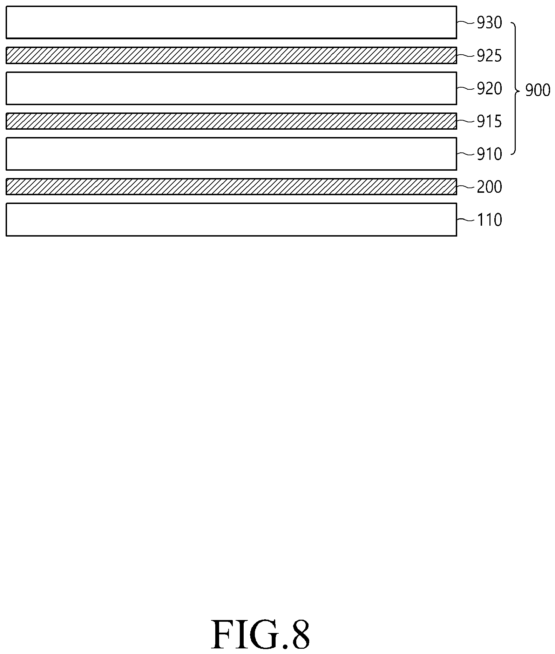

FIGS. 7 and 8 are views illustrating an example in which a plurality of functional members are included.

Referring to FIG. 7, a display device 100 according to aspects of the disclosure can include a display panel 110, an adhesive layer 200, and a plurality of functional members 800. The adhesive layer 200 can be disposed between the display panel 110 and the plurality of functional members 800. The display panel 110 and the plurality of functional members 800 are bonded by the adhesive layer 200.

The plurality of functional members 800 can include a first functional member 810, a first additional adhesive layer 815, and a second functional member 820. The first additional adhesive layer 815 can be disposed between the first functional member 810 and the second functional member 820. The first functional member 810 and the second functional member 820 are bonded by the first additional adhesive layer 815.

The first functional member 810 can be a functional panel such as a touch panel or a 3D barrier panel. The first functional member 810 can be a light control film for adjusting the viewing angle area of the display device. In example embodiments of the disclosure, the first functional member 810 is not limited to the above-described substrates or panels.

As one example, the first functional member 810 can include a base substrate.

The base substrate can have a thickness of 0.5T or more and 1.0T or less. When the thickness of the base substrate meets the above-mentioned range, stress can be released, preventing delamination between layers.

The second functional member 820 can be a cover window for protecting the display device, or can be a functional panel such as a touch panel or a 3D barrier panel. The second functional member 820 can be a light control film for adjusting the viewing angle area of the display device. In example embodiments of the disclosure, the functional member is not limited to the above-described substrates or panels.

As one example, the second functional member 820 can include a base substrate.

The base substrate can have a thickness of 0.5mm or more and 1.0 mm or less. When the thickness of the base substrate meets the above-mentioned range, stress can be released, preventing delamination between layers.

The first functional member 810 and the second functional member 820 can be different substrates or panels among the substrates or panels described above.

The first additional adhesive layer 815 disposed between the first functional member 810 and the second functional member 820 can have a low storage modulus and a high creep, preventing or reducing mura defects and mitigating stress to the outside even at high temperatures and resultantly providing an enhanced adhesive strength.

As one example, the first additional adhesive layer 815 can have a creep value of 100% or more and a storage modulus value of 55 KPa or less at a first temperature, a creep value of 130% or more, and a storage modulus value of 20 KPa or less at a second temperature higher than the first temperature.

Specifically, the first additional adhesive layer 815 can have a creep value of 100% or more and a storage modulus value of 55 KPa or less at a temperature of 25°C, a creep value of 130% or more, and a storage modulus value of 20 KPa or less at a temperature of 105°C.

The first additional adhesive layer 815 can have a creep value of 250% or less and a storage modulus value of 34 KPa or more at a temperature of 25°C.

The first additional adhesive layer 815 can have a creep value of 350% or less and a storage modulus value of 4 KPa or more at a temperature of 105°C.

The first additional adhesive layer 815 can have a creep value of 100% or more and 250% or less, a storage modulus value of 34 KPa or more and 55 KPa or less at a temperature of 25°C.

The first additional adhesive layer 815 can have a creep value of 130% or more and 350% or less, and a storage modulus value of 4 KPa or more and 20 KPa or less at a temperature of 105°C.

When the creep value and the storage modulus value meet the above-described ranges at temperatures of 25°C and 105°C, the first additional adhesive layer 815 can prevent or reduce mura defects, and can have an enhanced adhesive strength by relieving stress to the outside even at high temperatures.

As one example, the first additional adhesive layer 815 can also have a thickness of 150 µm or more and 750 µm or less, a thickness of 200 µm or more and 400 µm or less, and a thickness of 250 µm or more and 350 µm or less. Further, other suitable thicknesses of the first additional adhesive layer 815 are also possible, as long as the display panel can reduce the stress received from the outside to prevent or reduce mura defects, and can have an enhanced adhesive strength by relieving the stress to the outside even at high temperatures.

When the thickness of the first additional adhesive layer 815 meets the above-described ranges, the display panel can reduce the stress received from the outside to prevent or reduce mura defects, and can have an enhanced adhesive strength by relieving the stress to the outside even at high temperatures.

Referring to FIG. 8, a display device 100 according to aspects of the disclosure can include a display panel 110, an adhesive layer 200, and a plurality of functional members 900. The adhesive layer 200 can be disposed between the display panel 110 and the plurality of functional members 900. The display panel 110 and the plurality of functional members 900 are bonded by the adhesive layer 200.

The plurality of functional members 900 can include a first functional member 910, a first additional adhesive layer 915, a second functional member 920, a second additional adhesive layer 925, and a third functional member 930. The first additional adhesive layer 915 can be disposed between the first functional member 910 and the second functional member 920. The second additional adhesive layer 925 can be disposed between the third functional member 930 and the second functional member 920.

The first functional member 910 can be a functional panel such as a touch panel or a 3D barrier panel. The first functional member 910 can be a light control film for adjusting the viewing angle area of the display device. In example embodiments of the disclosure, the first functional member 910 is not limited to the above-described substrates or panels.

As one example, the first functional member 910 can include a base substrate.

The base substrate can have a thickness of 0.5 mm or more and 1.0 mm or less. When the thickness of the base substrate meets the above-mentioned range, stress can be released, preventing delamination between layers.

The second functional member 920 can be a cover window for protecting the display device, or can be a functional panel such as a touch panel or a 3D barrier panel. The second functional member 920 can be a light control film for adjusting the viewing angle area of the display device. In example embodiments of the disclosure, the functional member is not limited to the above-described substrates or panels.

As one example, the second functional member 920 can include a base substrate.

The base substrate can have a thickness of 0.5T or more and 1.0T or less. When the thickness of the base substrate meets the above-mentioned range, stress can be released, preventing delamination between layers.

The third functional member 930 can be a cover window for protecting the display device, or can be a functional panel such as a touch panel or a 3D barrier panel. The third functional member 930 can be a light control film for adjusting the viewing angle area of the display device. In example embodiments of the disclosure, the functional member is not limited to the above-described substrates or panels.

The third functional member 930 can include a base substrate.

The base substrate can have a thickness of 0.5 mm or more and 1.0 mm or less. When the thickness of the base substrate meets the above-mentioned range, stress can be released, preventing delamination between layers.

The first functional member 910, the second functional member 930, and the third functional member 930 can be different substrates or panels among the substrates or panels described above.

The first additional adhesive layer 915 can be disposed between the first functional member 910 and the second functional member 920. The second additional adhesive layer 925 can be disposed between the second functional member 920 and the third functional member 930. The first additional adhesive layer 915 and the second additional adhesive layer 925 can each independently have a low storage modulus and a high creep, preventing or reducing mura defects and mitigating stress to the outside even at high temperatures and resultantly providing an enhanced adhesive strength.

Specifically, the first additional adhesive layer 915 and the second additional adhesive layer 925 can each independently have a creep value of 100% or more and a storage modulus value of 55 KPa or less at a temperature of 25°C, a creep value of 130% or more, and a storage modulus value of 20 KPa or less at a temperature of 105°C.

The first additional adhesive layer 915 and the second additional adhesive layer 925 can each independently have a creep value of 250% or less and a storage modulus value of 34 KPa or more at a temperature of 25°C.

The first additional adhesive layer 915 and the second additional adhesive layer 925 can each independently have a creep value of 350% or less and a storage modulus value of 4 KPa or more at a temperature of 105°C.

The first additional adhesive layer 915 and the second additional adhesive layer 925 can each independently have a creep value of 100% or more and 250% or less, a storage modulus value of 34 KPa or more and 55 KPa or less at a temperature of 25°C.

The first additional adhesive layer 915 and the second additional adhesive layer 925 can each independently have a creep value of 130% or more and 350% or less, and a storage modulus value of 4 KPa or more and 20 KPa or less at a temperature of 105°C.

When the creep value and the storage modulus value meet the above-described ranges at temperatures of 25°C and 105°C, the first additional adhesive layer 915 and the second additional adhesive layer 925 can prevent or reduce mura defects, and can have an enhanced adhesive strength by relieving stress to the outside even at high temperatures.

As one example, the first additional adhesive layer 915 and the second additional adhesive layer 925 can each independently also have a thickness of 150 µm or more and 750 µm or less, a thickness of 200 µm or more and 400 µm or less, and a thickness of 250 µm or more and 350 µm or less. Further, other suitable thicknesses of the first additional adhesive layer 915 and the second additional adhesive layer 925 are also possible, as long as the display panel can reduce the stress received from the outside to prevent or reduce mura defects, and can have an enhanced adhesive strength by relieving the stress to the outside even at high temperatures.

When the thickness of the first additional adhesive layer 915 and the second additional adhesive layer 925 meets the above-described ranges, the display panel can reduce the stress received from the outside to prevent or reduce mura defects, and can have an enhanced adhesive strength by relieving the stress to the outside even at high temperatures.

Hereinafter, a display device according to example embodiments of the disclosure is described in detail with reference to embodiments.

### [Experimental example]

Adhesive layers between the display panel and the cover window were formed using the adhesive materials of embodiments 1 to 4 and comparative examples 1 to 4 having the physical properties shown in Table 1 below.

**[Table 1]**

| | Storage Modulus (Pa) | | Creep (%) | |
|---|---|---|---|---|
| | 25°C | 105°C | 25°C | 105°C |
| Embodiment 1 | 5.4×10⁴ | 2.0×10⁴ | 108 | 137 |
| Embodiment 2 | 3.7×10⁴ | 1.0×10⁴ | 224 | 339 |
| Embodiment 3 | 3.4×10⁴ | 0.4×10⁴ | 246 | 240 |
| Embodiment 4 | 4.6×10⁴ | 1.2×10⁴ | 192 | 188 |
| comparative example 1 | 3.1×10⁴ | 1.6×10⁴ | 96 | 52 |
| comparative example 2 | 3.8×10⁴ | 2.1×10⁴ | 75 | 56 |
| comparative example 3 | 3.4×10⁴ | 1.7×10⁴ | 113 | 121 |
| comparative example 4 | 3.7×10⁴ | 2.1×10⁴ | 77 | 84 |

Table 2 below shows the physical property results related to operation, preservation evaluation, and reliability over 500 hours, wherein the acronym NG refers to a reliability level "not good".

**[Table 2]**

| | | Operation | | | Preservation | | Reliabilit y |
|---|---|---|---|---|---|---|---|
| | | 85°C | 65°C 90% | -40°C | 95°C | 40 to 95°C | |
| Embodiment 1 | grating | 0 | 0 | 0 | 0 | 0 | OK |
| | striping | 0 | 0 | 0 | 0 | 0 | |
| | 4-sided yellowing | 0 | 0 | 0 | 0 | 0 | |
| Embodiment 2 | grid | 0 | 0 | 0 | 0 | 0 | OK |
| | striping | 0 | 0 | 0 | 0 | 0 | |
| | 4-sided yellowing | 1 | 1 | 0 | 1 | 1 | |
| Embodiment 3 | grid | 0 | - | 0 | 0 | 0 | OK |
| | striping | 0 | - | 0 | 0 | 0 | |
| | 4-sided yellowing | 1 | - | 0 | 0 | 0 | |
| Embodiment 4 | grating | 0 | - | - | 0 | - | OK |
| | striping | 0 | - | - | 0 | - | |
| | 4-sided yellowing | 1 to 2 | - | - | 0 to 2 | - | |
| Comparative example 1 | grating | 4 | 3 | 0 | 4 | 0 | NG |
| | striping | 3 | 3 | 0 | 4 | 3 | |
| | 4-sided yellowing | 2 | 2 | 0 | 2 | 2 | |
| Comparative example 2 | grating | 3 | - | - | 3 | 3 | NG |
| | striping | 3 | - | - | 0 | 0 | |
| | 4-sided yellowing | 3 | - | - | 2 | 2 | |
| Comparative example 3 | grating | 4 | - | - | 3 | - | NG |
| | striping | 4 | - | - | 4 | - | |
| | 4-sided yellowing | 1 | - | - | 1 | - | |
| Comparative example 4 | grating | - | - | - | 2 | - | NG |
| | striping | - | - | - | 0 | - | |
| | 4-sided yellowing | - | - | - | 3 | - | |

Referring to Table 2, it can be identified that in the embodiments 1 to 4 including the adhesive material according to example embodiments of the disclosure, there is no or insignificant occurrence of grating, striping, and four-sided yellowing in the operation and preservation evaluation. Further, it can be identified that all of embodiments 1 to 4 including the adhesive material according to example embodiments of the disclosure meet the reliability evaluation.

In contrast, it can be identified that in comparative examples 1 to 4, grating, striping, and four-sided yellowing occur in operation and preservation evaluation. It can also be identified that comparative examples 1 to 4 all fail to meet the reliability evaluation.

Table 3 below shows various ratios of the modulus and the creep for the adhesive materials of embodiments 1 to 4 and comparative examples 1 to 4 having the physical properties shown in Table 1.

**Table 3]**

| | Storage Modulus Ratio [MR] (105°C /25°C) | Creep Ratio [CR](105°C /25°C) | MR/CR |
|---|---|---|---|
| Embodiment 1 | 0.370 | 1.268 | 0.291 |
| Embodiment 2 | 0.270 | 1.513 | 0.178 |
| Embodiment 3 | 0.117 | 0.975 | 0.120 |
| Embodiment 4 | 0.260 | 0.979 | 0.265 |
| comparative example 1 | 0.516 | 0.541 | 0.953 |
| comparative example 2 | 0.552 | 0.746 | 0.739 |
| comparative example 3 | 0.500 | 1.070 | 0.467 |
| comparative example 4 | 0.567 | 1.090 | 0.520 |

Referring to Table 3, it can be identified that the modulus ratio MR of the storage modulus at a temperature of 105°C to the storage modulus at a temperature 105°C of 25°C can range from about 0.117 to about 0.370 for embodiments 1 to 4, while the modulus ratio MR of the storage moduli of the two temperatures (105°C /25°C) can range from about 0.500 to about 0.567 for comparative examples 1 to 4. Accordingly, the modulus ratio MR of the storage moduli of the two temperatures (105°C /25°C) for embodiments 1 to 4 can be less than about 0.500.

Also, it can be identified that the creep ratio CR of the creep at a temperature of 105°C to the creep value at a temperature of 25°C can range from about 0.975 to about 1.513 for embodiments 1 to 4, while the creep ratio CR of the creeps of the two temperatures (105°C /25°C) can range from about 0.541 to about 1.090 for comparative examples 1 to 4. Accordingly, the creep ratio CR of the creeps of the two temperatures (105°C /25°C) for embodiments 1 to 4 can be greater than about 0.975, for example, greater than about 1.090.

Additionally, a ratio of the MR to CR (MR/CR) can range from about 0.120 to about 0.290 for embodiments 1 to 4, while a ratio of the MR to CR (MR/CR) can range from about 0.467 to about 0.953 for comparative examples 1 to 4. Accordingly, the ratio of the MR to CR (MR/CR) can be less than about 0.467.

The above description has been presented to enable any person skilled in the art to make and use the technical idea of the disclosure, and has been provided in the context of a particular application and its requirements. Various modifications, additions and substitutions to the described embodiments will be readily apparent to those skilled in the art, and the general principles defined herein can be applied to other embodiments and applications. The above description and the accompanying drawings provide an example of the technical idea of the disclosure for illustrative purposes. For example, the disclosed embodiments are intended to illustrate the scope of the technical idea of the disclosure.

## Claims

1. A display device (100), comprising:
a display panel (110) configured to output an image;
a functional member (300, 600, 700, 800, 900) disposed on the display panel (110); and
an adhesive layer (200) disposed between the display panel (110) and the functional member (300, 600, 700, 800, 900),
wherein the adhesive layer (200) has a creep value of about 100% or more at a first temperature, and has the creep value of about 130% or more at a second temperature higher than the first temperature.

2. The display device (100) of claim 1, wherein the first temperature is about 25°C, and the second temperature is about 105°C.

3. The display device (100) of claim 2, wherein the adhesive layer (200) has the creep value of about 250% or less and the storage modulus value of about 34KPa or more at the temperature of about 25°C and/or
wherein the adhesive layer (200) has the creep value of about 350% or less and the storage modulus value of about 4KPa or more at the temperature of about 105°C.

4. The display device (100) of any one of claims 1-3, wherein the adhesive layer (200) has a thickness of about 150 *µ*m or more and about 500 *µ*m or less.

5. The display device (100) of any one of claims 1-4, wherein the functional member (700) includes a base substrate, and
wherein the base substrate has a thickness of about 0.5 mm or more and about 1.0 mm or less.

6. The display device (100) of claim 5, wherein the base substrate includes an upper base substrate (720) and a lower base substrate (710) facing each other, and
wherein at least one of the upper base substrate (720) and the lower base substrate (710) has the thickness of about 0.5 mm or more and about 1.0 mm or less.

7. The display device (100) of any one of claims 1-6, wherein the display panel (110) includes a display substrate (401, 501), and
wherein the display substrate (401, 501) has a thickness of about 0.5 mm or more and about 1.0 mm or less.

8. The display device (100) of claim 7, wherein the display panel (110) includes:
the display substrate including an upper display substrate (441) and a lower display substrate (401);
a column spacer (433) disposed on the upper display substrate (441) or the lower display substrate (401); and
a display liquid crystal layer (431) positioned between the upper display substrate (441) and the lower display substrate (401), and
wherein the column spacer (433) is distributed at an arrangement density of about 100 ppm or more and about 750 ppm or less.

9. The display device (100) of claim 7, wherein the display panel (110) includes a light emitting element including:
a first electrode (511) disposed on the display substrate (501);
a light emitting layer (512) disposed on the first electrode (511); and
a second electrode (513) disposed on the light emitting layer (512), and
wherein the light emitting element is any one of an organic electroluminescent element (510), a quantum dot light emitting element, a micro light emitting diode LED, and a mini LED.

10. The display device (100) of any one of claims 1-9, wherein the functional member (300, 600, 700, 800, 900) is any one of a cover window (600), a touch panel, a barrier panel (700), and a light control film.

11. The display device (100) of any one of claims 1-10, wherein:
a modulus ratio (MR) of the second temperature to the first temperature for the adhesive layer (200) ranges from about 0.117 to about 0.370, or
a creep ratio (CR) of the second temperature to the first temperature for the adhesive layer (200) ranges from about 0.975 to about 1.513, or
a ratio of the MR to CR (MR/CR) of the adhesive layer (200) ranges from about 0.120 to about 0.290.

12. The display device (100) of any one of claims 1-11, further comprising:
a first functional member (810, 910) disposed on the display panel (110);
a second functional member (820, 920) disposed on the first functional member (810, 910); and
a first additional adhesive layer (815, 915) disposed between the first functional member (810, 910) and the second functional member (820, 920),
wherein the first additional adhesive layer (815, 915) has a creep value of about 100% or more and preferably a storage modulus value of about 55KPa or less at a first temperature, and has a creep value of about 130% or more and preferably a storage modulus value of about 20KPa or less at a second temperature.

13. The display device (100) of claim 12, wherein the first additional adhesive layer (815, 915) has a creep value of 250% or less and a storage modulus value of 34KPa or more at a temperature of 25°C; and/or wherein the first additional adhesive layer (815, 915) has a creep value of 350% or less and a storage modulus value of 4KPa or more at a temperature of 105°C.

14. The display device (100) of claim 12 or 13, further comprising:
a third functional member (930) disposed on the second functional member (920); and
a second additional adhesive layer (925) disposed between the second functional member (920) and the third functional member (930),
wherein the second additional adhesive layer (920) has a creep value of about 100% or more and preferably a storage modulus value of about 55KPa or less at the first temperature, and has a creep value of about 130% or more and preferably a storage modulus value of about 20KPa or less at the second temperature.

15. The display device (100) of claim 14, wherein the second additional adhesive layer (925) has a thickness of 150 *µ*m or more and 500 *µ*m or less.
